# EUROPEAN PATENT APPLICATION

(11) **EP 4 823 264 A1**
(43) Date of publication of application: **14.10.2026**
(21) Application number: 26171791.2
(22) Date of filing: 10.04.2026
(51) Int. Cl.: H05K 7/20

(54) **COOLING SYSTEM FOR AIRCRAFT POWERPLANT ELECTRONICS**

(30) Priority: 11.04.2025 US 202519176942
(71) Applicant: RTX Corporation, Farmington, CT 06032 (US)
(72) Inventor: CLARK, Thomas E., Wells, 04090 (US); YAZICI, Murat, Glastonbury, 06033 (US)
(74) Representative: Dehns

(57) **Abstract**

An aircraft powerplant (20) assembly includes a first electric device (108A) and a cooling system (36). The first electric device (108A) includes a first device heat exchanger (160A), a first device housing (118A) and first electrical circuitry (120A). The cooling system (36) includes a liquid circuit (138), an air circuit (136) and a system heat exchanger (140). The cooling system (36) is configured to cool the first electrical circuitry (120A) using a liquid flowing in the liquid circuit (138) and air flowing in the air circuit (136). The liquid circuit (138) extends through the system heat exchanger (140) and the first electric device (108A). The first device heat exchanger (160A) is configured to transfer heat energy from the first electrical circuitry (120A) into the liquid in the liquid circuit (138). The air circuit (136) extends through the system heat exchanger (140). The system heat exchanger (140) is configured to transfer at least some of the heat energy from the liquid in the liquid circuit (138) into the air in the air circuit (136).

## Description

### Technical Field

This disclosure relates generally to an aircraft and, more particularly, to a cooling system for a powerplant of the aircraft.

### Background Information

An aircraft powerplant includes various components which utilize cooling during aircraft powerplant operation. Various cooling systems and methods are known in the art. While these known cooling systems and methods have various benefits, there is still room in the art for improvement.

### SUMMARY

According to an aspect of the present invention, an assembly is provided for an aircraft powerplant. This assembly includes a first electric device and a cooling system. The first electric device includes a first device heat exchanger, a first device housing and first electrical circuitry housed within an interior of the first device housing. The cooling system includes a liquid circuit, an air circuit and a system heat exchanger. The cooling system is configured to cool the first electrical circuitry using a liquid flowing in the liquid circuit and air flowing in the air circuit. The liquid circuit extends through the system heat exchanger and the first electric device. The first device heat exchanger is configured to transfer heat energy from the first electrical circuitry into the liquid in the liquid circuit. The air circuit extends through the system heat exchanger. The system heat exchanger is configured to transfer at least some of the heat energy from the liquid in the liquid circuit into the air in the air circuit. The first device housing is attached to the system heat exchanger.

According to another aspect of the present invention, another assembly is provided for an aircraft powerplant. This assembly includes an electric machine, an electric machine controller and a cooling system. The electric machine controller is configured to control operation of the electric machine. The electric machine controller includes a controller heat exchanger, a controller housing and controller circuitry housed within an interior of the controller housing. The cooling system includes a closed loop liquid circuit and a system heat exchanger. The closed loop cooling system is configured to cool the controller circuitry using a liquid flowing in the liquid circuit. The electric machine controller is thermally coupled to the system heat exchanger through conduction.

According to still another aspect of the present invention, another assembly is provided for an aircraft powerplant. This assembly includes a first electric device and a cooling system. The first electric device includes a first device heat exchanger, a first device housing and first electrical circuitry housed within an interior of the first device housing. The cooling system includes a liquid circuit and a system heat exchanger. The cooling system is configured to cool the first electrical circuitry using a liquid flowing in the liquid circuit. The liquid circuit extends through the system heat exchanger and the first electric device. The first device heat exchanger is configured to transfer heat energy from the first electrical circuitry into the liquid in the liquid circuit. The system heat exchanger is configured to transfer at least some of the heat energy out of the liquid in the liquid circuit into air. The first device housing is attached to the system heat exchanger. The system heat exchanger has a length and a height. An aspect ratio of the length to the height is equal to or greater than ten.

In an embodiment of the above, the cooling system may also include an air circuit. The air circuit may extend through the system heat exchanger. The controller heat exchanger may be configured to transfer heat energy from the electrical circuitry into the liquid in the liquid circuit. The system heat exchanger may be configured to transfer at least some of the heat energy from the liquid in the liquid circuit into air in the air circuit.

In an embodiment according to any of the previous embodiments, the first device heat exchanger may be integrated with the first device housing.

In an embodiment according to any of the previous embodiments, the first device heat exchanger may be housed within the interior of the first device housing.

In an embodiment according to any of the previous embodiments, the first device heat exchanger may be conductively thermally coupled to the system heat exchanger.

In an embodiment according to any of the previous embodiments, the liquid circuit may be configured as a closed loop liquid circuit.

In an embodiment according to any of the previous embodiments, the liquid circuit may include a liquid reservoir, a liquid pump and a liquid path. The liquid path may be fluidly coupled to the liquid reservoir and may extend through the liquid pump, the system heat exchanger and the first device heat exchanger.

In an embodiment according to any of the previous embodiments, the liquid reservoir and/or the liquid pump may be disposed outside of the first electric device.

In an embodiment according to any of the previous embodiments, the assembly may also include a powerplant housing comprising an internal compartment. The first electric device, the system heat exchanger, the liquid reservoir and the liquid pump may be disposed within the internal compartment.

In an embodiment according to any of the previous embodiments, the assembly may also include a powerplant housing that includes an internal compartment. The first electric device and the system heat exchanger may be arranged within the internal compartment.

In an embodiment according to any of the previous embodiments, the liquid may be or otherwise include lubricant.

In an embodiment according to any of the previous embodiments, the air circuit may include a flow regulator configured to regulate a flow of the air through the system heat exchanger.

In an embodiment according to any of the previous embodiments, an inlet into the air circuit may be fluidly coupled to an environment external to the aircraft powerplant.

In an embodiment according to any of the previous embodiments, an inlet into the air circuit may be fluidly coupled to a volume within the aircraft powerplant.

In an embodiment according to any of the previous embodiments, an outlet from the air circuit may be fluidly coupled to an environment external to the aircraft powerplant.

In an embodiment according to any of the previous embodiments, an outlet from the air circuit may be fluidly coupled to a volume within the aircraft powerplant.

In an embodiment according to any of the previous embodiments, the assembly may also include a second electric device that includes a second device heat exchanger, a second device housing and second electrical circuitry housed within an interior of the second device housing. The cooling system may be configured to cool the second electrical circuitry using the liquid flowing in the liquid circuit and the air flowing in the air circuit. The liquid circuit may also extend through the second electric device. The second device heat exchanger may be configured to transfer additional heat energy from the second electrical circuitry into the liquid in the liquid circuit. The second device housing may be attached to the system heat exchanger.

In an embodiment according to any of the previous embodiments, the system heat exchanger may have a length and a height. An aspect ratio of the length to the height may be equal to or greater than ten.

In an embodiment according to any of the previous embodiments, the assembly may also include an electric machine. The first electric device may be an electric machine controller configured to control operation of the electric machine.

In an embodiment according to any of the previous embodiments, the first electric device may be configured as or otherwise include an electronic engine controller.

In an embodiment according to any of the previous embodiments, the assembly may also include a powerplant housing, an engine core and a propulsor rotor. The powerplant housing may include an internal compartment. The first electric device and the system heat exchanger may be arranged within the internal compartment. The engine core may be housed within the powerplant housing. The engine core may include a flowpath, a compressor section, a combustor section and a turbine section. The flowpath may extend through the compressor section, the combustor section and the turbine section. The engine core may be configured to drive rotation of the propulsor rotor.

In an embodiment according to any of the previous embodiments, the propulsor rotor may be housed within the powerplant housing.

In an embodiment according to any of the previous embodiments, the propulsor rotor may be an open propulsor rotor.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system with a ducted propulsor rotor.
FIG. 2 is a schematic illustration of a portion of the aircraft propulsion system at an electric machine system.
FIG. 3 is a schematic illustration of a portion of the aircraft propulsion system at a cooling system.
FIGS. 4 and 5 are schematic illustrations of a portion of the aircraft propulsion system with various controller heat exchanger arrangements.
FIG. 6 is a schematic cross-sectional illustration of the aircraft propulsion system at the cooling system.
FIG. 7 is a plan view illustration of a cooling system heat exchanger.
FIG. 8 is a schematic illustration of the aircraft propulsion system with an open propulsor rotor.

### DETAILED DESCRIPTION

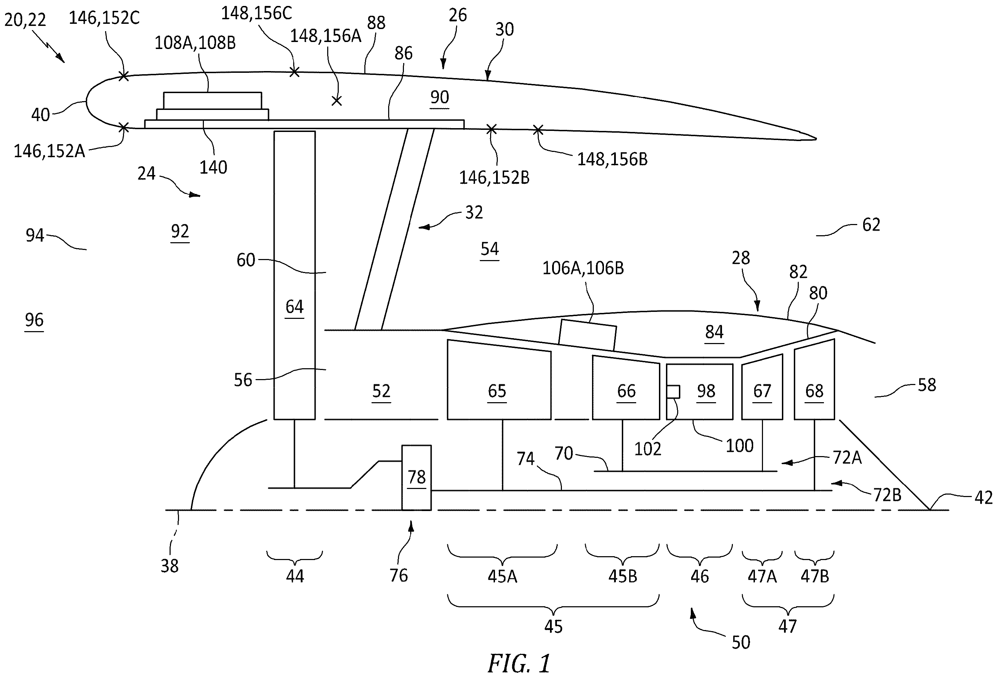

FIG. 1 illustrates a powerplant 20 for an aircraft. The aircraft may be an airplane, a drone (e.g., an unmanned aerial vehicle (UAV)) or any other manned or unmanned aerial vehicle or system. For ease of description, the aircraft powerplant 20 is described below as a propulsion system 22 for the aircraft such as a turbofan propulsion system. The aircraft powerplant 20 of the present disclosure, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted and/or open rotor propulsion system. Moreover, the aircraft powerplant 20 is not limited to propulsion system applications. The aircraft powerplant 20, for example, may also (or alternatively) be configured as an electrical power system for the aircraft; e.g., an auxiliary power unit (APU).

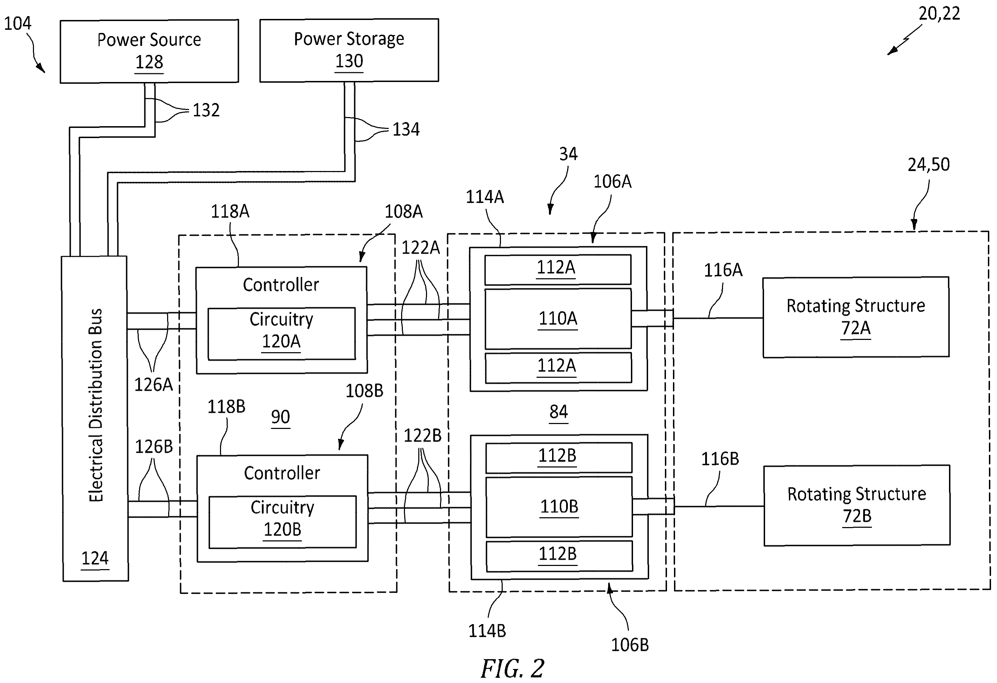

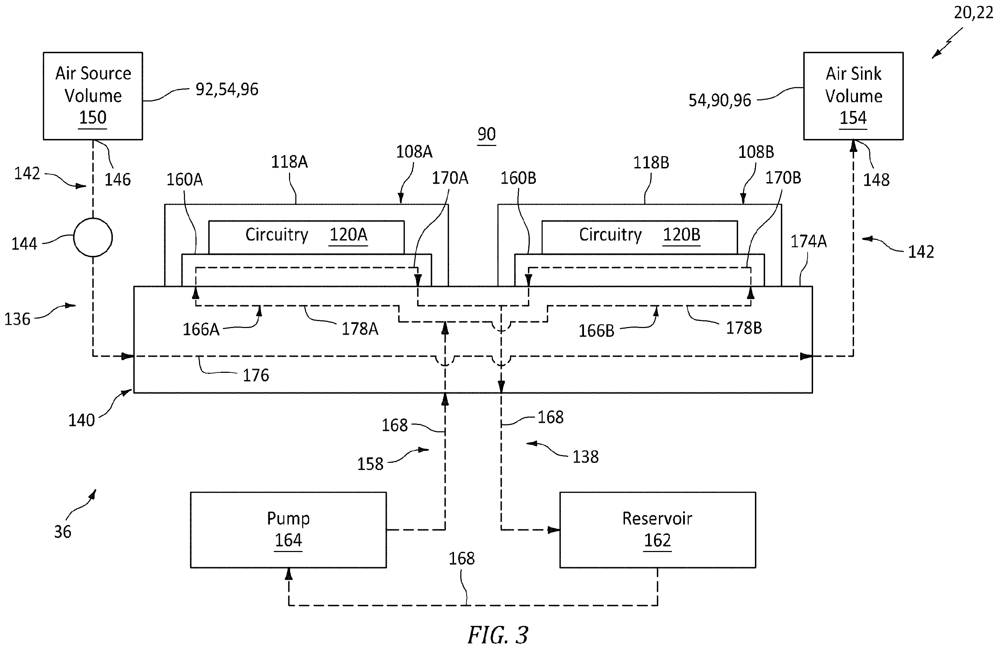

The aircraft propulsion system 22 includes a gas turbine engine 24 (e.g., a turbofan engine) housed within a stationary propulsion system housing 26 (more generally, a powerplant housing), which propulsion system housing 26 of FIG. 1 includes an inner housing structure 28, an outer housing structure 30 and a guide vane structure 32 (e.g., a fan exit guide vane (FEGV) structure) extending radially between and connected to the inner housing structure 28 and the outer housing structure 30. The aircraft propulsion system 22 also includes an electric machine system 34 (see FIG. 2) and a cooling system 36 (see FIG. 3). The aircraft propulsion system 22 extends axially along a propulsion system axis 38 (more generally, a powerplant axis) between an axial upstream, forward end 40 of the aircraft propulsion system 22 and an axial downstream, aft end 42 of the aircraft propulsion system 22. Briefly, the propulsion system axis 38 may be a centerline axis of the aircraft propulsion system 22, the turbine engine 24 and/or one or more of its members. The propulsion system axis 38 may also or alternatively be a rotational axis for one or more members of the turbine engine 24.

The aircraft propulsion system 22 and its turbine engine 24 of FIG. 1 include a propulsor section 44 (e.g., a fan section), a compressor section 45, a combustor section 46 and a turbine section 47. The compressor section 45 of FIG. 1 includes a low pressure compressor (LPC) section 45A and a high pressure compressor (HPC) section 45B. The turbine section 47 of FIG. 1 includes a high pressure turbine (HPT) section 47A and a low pressure turbine (LPT) section 47B. At least (or only) the LPC section 45A, the HPC section 45B, the combustor section 46, the HPT section 47A and the LPT section 47B collectively form a core 50 (e.g., a gas generator) of the turbine engine 24. The aircraft propulsion system 22 and its turbine engine 24 of FIG. 1 also include a core flowpath 52 (e.g., an annular core flowpath) and a bypass flowpath 54 (e.g., an annular bypass flowpath). The core flowpath 52 extends sequentially through the LPC section 45A, the HPC section 45B, the combustor section 46, the HPT section 47A and the LPT section 47B from an airflow inlet 56 into the core flowpath 52 to a combustion products exhaust 58 out from the core flowpath 52. The bypass flowpath 54 extends through a bypass duct from an airflow inlet 60 into the bypass flowpath 54 to an airflow exhaust 62 from the bypass flowpath 54, where the bypass duct may be formed by the inner housing structure 28 and the outer housing structure 30. The bypass flowpath 54 and its bypass duct are configured to bypass (e.g., are disposed radially outboard of and extend along) the engine core 50 and the inner housing structure 28.

The propulsor section 44, the LPC section 45A, the HPC section 45B, the combustor section 46, the HPT section 47A and the LPT section 47B may be arranged sequentially along the propulsion system axis 38 within the propulsion system housing 26. The propulsor section 44 includes a bladed propulsor rotor 64; e.g., a fan rotor. The LPC section 45A includes a bladed low pressure compressor (LPC) rotor 65. The HPC section 45B includes a bladed high pressure compressor (HPC) rotor 66. The HPT section 47A includes a bladed high pressure turbine (HPT) rotor 67. The LPT section 47B includes a bladed low pressure turbine (LPT) rotor 68. Each of these engine rotors 64-68 includes a rotor base (e.g., a disk or a hub) and a plurality of rotor blades (e.g., airfoils, vanes, etc.). The rotor blades may be arranged into one or more stages axially along the respective engine rotor 64-68. The rotor blades in each stage are arranged and may be equispaced circumferentially around the respective rotor base in an annular array. Each of the rotor blades is connected to the respective rotor base. The rotor blades, for example, may be formed integral with or mechanically fastened, welded, brazed and/or otherwise attached to the respective rotor base. Each of the rotor blades projects spanwise (e.g., radially) out from the respective rotor base to a distal tip of the respective rotor blade.

The HPC rotor 66 is coupled to and rotatable with the HPT rotor 67. The HPC rotor 66 of FIG. 1, for example, is connected to the HPT rotor 67 through a high speed shaft 70. At least (or only) the HPC rotor 66, the HPT rotor 67 and the high speed shaft 70 collectively form a high speed rotating structure 72A; e.g., a high speed spool of the turbine engine 24 and its engine core 50. This high speed rotating structure 72A of FIG. 1 and its members 66, 67 and 70 are rotatable about the propulsion system axis 38. However, it is contemplated the high speed rotating structure 72A may alternatively be rotatable about another axis radially and/or angularly offset from the rotational axis of the propulsor rotor 64 and/or the centerline axis of the turbine engine 24.

The LPC rotor 65 is coupled to and rotatable with the LPT rotor 68. The LPC rotor 65 of FIG. 1, for example, is connected to the LPT rotor 68 through a low speed shaft 74. At least (or only) the LPC rotor 65, the LPT rotor 68 and the low speed shaft 74 collectively form a low speed rotating structure 72B; e.g., a low speed spool of the turbine engine 24 and its engine core 50. This low speed rotating structure 72B of FIG. 1 and its members 65, 68 and 74 are rotatable about the propulsion system axis 38. However, it is contemplated the low speed rotating structure 72B may alternatively be rotatable about another axis radially and/or angularly offset from the rotational axis of the propulsor rotor 64 and/or the centerline axis of the turbine engine 24.

The low speed rotating structure 72B is coupled to the propulsor rotor 64 through a rotating structure-to-propulsor (RSP) drivetrain 76. The RSP drivetrain 76 may be configured as a geared drivetrain, where a geartrain 78 (e.g., a transmission, a speed change device, an epicyclic geartrain, etc.) is disposed between and operatively couples the propulsor rotor 64 to the low speed rotating structure 72B and its LPT rotor 68. With this arrangement, the propulsor rotor 64 may rotate at a different (e.g., slower) rotational speed than the low speed rotating structure 72B and its LPT rotor 68. Here, the propulsor rotor 64 and the low speed rotating structure 72B may rotate in a common (the same) direction about the propulsion system axis 38 or in opposite directions about the propulsion system axis 38 depending, for example, upon the specific configuration of the geartrain 78. Alternatively, the RSP drivetrain 76 may be configured as a direct-drive drivetrain, where the geartrain 78 is omitted. With such an arrangement, the propulsor rotor 64 rotates at a common (the same) rotational speed as the low speed rotating structure 72B and its LPT rotor 68.

The inner housing structure 28 of FIG. 1 includes an inner case 80 (e.g., a core case) for the turbine engine 24, an inner nacelle structure 82 (sometimes referred to as an inner fixed structure (IFS)) and an internal inner housing compartment 84 (e.g., an engine core compartment). The inner case 80 is disposed radially outboard of, extends axially along and may circumscribe one or more or all of the engine sections 45A-47B and the engine rotors 65-68. The inner case 80 may thereby house and provide a support structure for the respective engine sections 45A-47B and the engine rotors 65-68. The inner nacelle structure 82 is configured to provide an aerodynamic cover over the engine core 50 and its inner case 80. The inner housing compartment 84 of FIG. 1 is formed by and is disposed radially between the inner case 80 and an inner barrel of the inner nacelle structure 82. The inner housing structure 28 and its inner nacelle structure 82 may also form a radial inner peripheral boundary of the bypass flowpath 54.

The outer housing structure 30 of FIG. 1 includes an outer case 86 (e.g., a fan case) for the turbine engine 24, an outer nacelle structure 88 and an internal outer housing compartment 90. The outer case 86 is disposed radially outboard of, extends axially along and may circumscribe the propulsor section 44 and its propulsor rotor 64. The outer case 86 may thereby house and may be configured as a containment structure for the propulsor section 44 and its propulsor rotor 64. The outer nacelle structure 88 is configured to provide an aerodynamic cover over the outer case 86. The outer housing compartment 90 of FIG. 1 is at least partially formed by and disposed radially between the outer case 86 and an outer portion (e.g., fan cowls) of the outer nacelle structure 88. An aft portion of the outer housing structure 30 may form a radial outer peripheral boundary of the bypass flowpath 54. A forward portion of the outer housing structure 30 may also form a radial outer peripheral boundary of an inlet flowpath 92. This inlet flowpath 92 projects into the aircraft propulsion system 22 from an airflow inlet 94 into the aircraft propulsion system 22 to or about the propulsor rotor 64.

During operation of the aircraft propulsion system 22 of FIG. 1, ambient air from an environment 96 external to the aircraft and its aircraft propulsion system 22 enters the aircraft propulsion system 22 and its turbine engine 24 through the propulsion system inlet 94. From the propulsion system inlet 94, the incoming air is directed through the inlet flowpath 92 into the propulsor section 44 and to the propulsor rotor 64. The air received by the propulsor section 44 is propelled by the rotating propulsor rotor 64 in a downstream, aft direction towards the propulsion system aft end 42.

An outer stream of the air propelled by the rotating propulsor rotor 64 is directed into the bypass flowpath 54 through its bypass inlet 60, which air entering the bypass flowpath 54 may be referred to as "bypass air". The guide vane structure 32 conditions (e.g., straightens out, de-swirls, etc.) the flow of the bypass air within the bypass duct. This conditioned bypass air is subsequently directed out of the aircraft propulsion system 22 through the bypass exhaust 62 to provide forward thrust. This propulsion of the bypass air may account for a majority of the forward thrust generated by the aircraft propulsion system 22 and its turbine engine 24 of FIG. 1.

An inner stream of the air propelled by the rotating propulsor rotor 64 is directed into the core flowpath 52 through its core inlet 56, which air entering the core flowpath 52 may be referred to as "core air". This core air is compressed by the LPC rotor 65 and the HPC rotor 66 and is directed into a combustion chamber 98 (e.g., annular combustion chamber) of a combustor 100 (e.g., annular combustor) in the combustor section 46. Fuel is injected into the combustion chamber 98 by one or more fuel injectors 102 and mixed with the compressed core air to provide a fuel-air mixture. This fuel-air mixture is ignited and combustion products thereof flow through and sequentially drive rotation of the HPT rotor 67 and the LPT rotor 68. The rotation of the HPT rotor 67 and the LPT rotor 68 respectively drive rotation of the HPC rotor 66 and the LPC rotor 65 and, thus, compression of the air received from the core inlet 56. The rotation of the LPT rotor 68 also drives rotation of the propulsor rotor 64 through the RSP drivetrain 76.

Referring to FIG. 2, the electric machine system 34 is electrically coupled to an electrical system 104 for the aircraft and its aircraft propulsion system 22. The electric machine system 34 of FIG. 2 includes one or more electric machines 106A and 106B (generally referred to as "106") and one or more electric machine (EM) controllers 108A and 108B (generally referred to as "108"). For ease of description, each electric machine 106 of FIG. 2 is described below as being electrically coupled to, controlled by and/or otherwise associated with a single, dedicated one of the EM controllers 108. However, it is contemplated a single EM controller may alternatively be electrically coupled to, may control and/or may otherwise be associated with multiple electric machines. It is also contemplated multiple EM controllers may be electrically coupled to, may control and/or may otherwise be associated with one or more common electric machines.

Each electric machine 106A, 106B of FIG. 2 includes an electric machine rotor 110A, 110B (generally referred to as "110"), an electric machine stator 112A, 112B (generally referred to as "112") and an electric machine housing 114A, 114B (generally referred to as "114"); e.g., a case. The machine rotor 110 is rotatable about a rotational axis of the machine rotor 110, which machine axis may also be an axial centerline of the electric machine 106. The machine stator 112 is disposed next to and in electromagnetic communication with the machine rotor 110. The machine stator 112 of FIG. 2, in particular, is radially outboard of and circumscribes the machine rotor 110. With this arrangement, each electric machine 106 is configured as a radial flux electric machine. The electric machines 106 of the present disclosure, however, are not limited to such an exemplary rotor-stator configuration nor to radial flux arrangements. The machine rotor 110, for example, may alternatively be radially outboard of and circumscribe the machine stator 112. In another example, the machine rotor 110 may be axially next to the machine stator 112 configuring the respective electric machine 106 as an axial flux electric machine. Referring again to FIG. 2, the machine rotor 110 and the machine stator 112 are at least partially or completely housed within and interior of the machine housing 114.

Each electric machine 106A, 106B is operatively coupled to a respective one of the engine rotating structures 72A, 72B (generally referred to as "72"). Each machine rotor 110A, 110B of FIG. 2, for example, is mechanically coupled to the respective engine rotating structure 72A, 72B through a respective electric machine-to-engine (EME) drivetrain 116A, 116B (generally referred to as "116"); schematically shown. This EME drivetrain 116 may be configured as or otherwise include a shaft, a tower shaft assembly, another gearbox (e.g., an angle gearbox), and/or the like. For ease of description, each machine rotor 110 of FIG. 2 is described below as being coupled to and rotatable with a unique one of the engine rotating structures 72 of the aircraft propulsion system 22. However, it is contemplated multiple machine rotors may alternatively be coupled to and rotatable with a common engine rotating structure. It is also contemplated a single one of the machine rotors may be coupled to and rotatable with multiple engine rotating structures, directly or through another device such as a differential or a clutch system.

Each electric machine 106 of FIG. 2 may be configurable as an electric motor and/or an electric generator; e.g., an electric motor-generator. For example, during a motor mode of operation, a respective electric machine 106 may operate as the electric motor to convert electricity received from the aircraft electrical system 104. The machine stator 112, for example, may generate an electromagnetic field with the machine rotor 110 using a current of electricity received from the aircraft electrical system 104 through the respective EM controller 108. This electromagnetic field may drive rotation of the machine rotor 110. The machine rotor 110, in turn, may provide mechanical power to and drive rotation of the respective engine rotating structure 72 through the respective EME drivetrain 116. This mechanical power may be provided to boost power or completely power the rotation of the respective engine rotating structure 72. By contrast, during a generator mode of operation, the electric machine 106 may operate as the electric generator to convert mechanical power received from the respective engine rotating structure 72 into electricity. Rotation of the machine rotor 110, for example, may be rotationally driven by rotation of the respective engine rotating structure 72 through the respective EME drivetrain 116. The rotation of the machine rotor 110 may generate an electromagnetic field with the machine stator 112, and the machine stator 112 may convert energy from the electromagnetic field into electricity. The respective electric machine 106 may then provide a current of electricity to the aircraft electrical system 104 through the respective EM controller 108 for storage and/or further use. The electric machines 106 of the present disclosure, however, are not limited to such exemplary operation. For example, one, some or all of the electric machines 106 may alternatively each be configured as a dedicated electric generator; e.g., without the electric motor functionality. One, some or all of the electric machines 106 may alternatively each be configured as a dedicated electric motor; e.g., without the electric generator functionality.

Each EM controller 108A, 108B includes a controller housing 118A, 118B (generally referred to as "118") and internal electrical controller circuitry 120A, 120B (generally referred to as "120"). The controller housing 118 may be configured as an enclosed case (e.g., a closed or sealed container) for the respective controller circuitry 120. The controller circuitry 120 is disposed within an interior of the controller housing 118; e.g., an internal chamber or other volume(s) within and enclosed by the controller housing 118. The controller circuitry 120 includes various electrical components, connectors and the like. Examples of the electrical components include, but are not limited to, printed circuit board(s) (PCB(s)), electrical inductor(s), electrical inverter(s), electrical amplifier(s), electrical switch(es) (e.g., contactor(s), relay(s), etc.), a processing device, memory, a communication module, electrical transformer(s), electrical rectifier(s), and/or the like.

Each EM controller 108A, 108B is electrically coupled to a respective one of the electric machines 106A, 106B through one or more electric cables 122A, 122B (generally referred to as "122"); e.g., high voltage electric cables, power feeder cables, etc. More particularly, the controller circuitry 120 of each EM controller 108 is electrically coupled to the respective electric machine 106 and its machine stator 112 through the respective electric cables 122. Similarly, each EM controller 108A, 108B is electrically coupled to an electrical distribution bus 124 of the aircraft electrical system 104 through one or more electric cables 126A, 126B (generally referred to as "126"); e.g., high voltage electric cables, power feeder cables, etc. More particularly, the controller circuitry 120 of each EM controller 108 is electrically coupled to the aircraft electrical system 104 and its electrical distribution bus 124 through the respective electric cables 126.

Each EM controller 108 and its controller circuitry 120 are configured to control operation of a respective one of the electric machines 106A, 106B. For example, when operating as the electric motor, the respective EM controller 108 and its controller circuitry 120 are configured to regulate a flow of electricity from the aircraft electrical system 104 to the respective electric machine 106. This electricity flow regulation may include: (a) turning-on the flow of electricity from the aircraft electrical system 104 to the respective electric machine 106 (e.g., electrically coupling the respective electric machine 106 to the aircraft electrical system 104); (b) turning-off the flow of electricity from the aircraft electrical system 104 to the respective electric machine 106 (e.g., electrically decoupling the respective electric machine 106 from the aircraft electrical system 104); (c) moderating the flow of electricity from the aircraft electrical system 104 to the respective electric machine 106. Here, the respective EM controller 108 operates as a motor controller. In another example, when operating as the electric generator, the respective EM controller 108 and its controller circuitry 120 are configured to regulate a flow of electricity from the respective electric machine 106 to the aircraft electrical system 104. This electricity flow regulation may include: (a) turning-on the flow of electricity from the respective electric machine 106 to the aircraft electrical system 104 (e.g., electrically coupling the respective electric machine 106 to the aircraft electrical system 104); (b) turning-off the flow of electricity from the respective electric machine 106 to the aircraft electrical system 104 (e.g., electrically decoupling the respective electric machine 106 from the aircraft electrical system 104); (c) moderating the flow of electricity from the respective electric machine 106 to the aircraft electrical system 104. Here, the respective EM controller 108 operates as a generator controller.

The aircraft electrical system 104 includes the electrical distribution bus 124. This aircraft electrical system 104 may also include a power source 128 and/or a power storage 130. The electrical distribution bus 124 is electrically coupled to each of the electric machines 106 through their respective EM controllers 108. The electrical distribution bus 124 is also electrically coupled to the power source 128 and the power storage 130 through one or more respective electric cables 132 and 134; e.g., high voltage electric cables, power feeder cables, etc. Of course, the electrical distribution bus 124 may also be electrically coupled to one or more additional electric components of the aircraft propulsion system 22 and/or one or more additional electric components of the aircraft outside of the aircraft propulsion system 22; e.g., airframe mounted electric components, etc. With this arrangement, the electrical distribution bus 124 provides an intermediate connection between the various electrical members 106A (via 108A), 106B (via 108B), 128 and/or 130. The power source 128 may be an electric generator powered by the turbine engine 24 (see FIG. 1) or an electric generator powered by another aircraft powerplant; e.g., an engine of a companion aircraft propulsion system, an engine of an auxiliary power unit (APU), a fuel cell system, etc. The power storage 130 is configured to receive electricity from the electrical distribution bus 124 for storage. The power storage 130 is also configured to provide the stored electricity to the electrical distribution bus 124. The power storage 130, for example, may be configured as or otherwise include one or more electricity storage devices; e.g., batteries, super capacitors, etc. Of course, it is contemplated one of the electric machines 106A, 106B (e.g., operating as the electric generator) may also or alternatively operate as a power source for another one of the electric machines 106B, 106A (e.g., operating as the electric motor).

Referring to FIG. 3, the cooling system 36 is configured to cool and/or otherwise service one or more electric devices such as the EM controllers 108A and 108B. The cooling system 36 of FIG. 3, for example, includes one or more cooling circuits such as a cooling system (CS) air circuit 136 and a cooling system (CS) liquid circuit 138. The cooling system 36 of FIG. 3 also includes a cooling system (CS) heat exchanger 140 shared by the CS air circuit 136 and the CS liquid circuit 138. This cooling system 36 and one or more or all of its members 136, 138 and/or 140 may be arranged in the outer housing compartment 90 along with the EM controllers 108; see also FIG. 1. The present disclosure, however, is not limited to such an exemplary cooling system location within the aircraft propulsion system 22.

The CS air circuit 136 of FIG. 3 includes an air circuit path 142, the CS heat exchanger 140 and a flow regulator 144. This CS air circuit 136 is thermally coupled to each EM controller 108 and its electrical circuitry 120 through the CS heat exchanger 140 as described below in further detail.

The air circuit path 142 of FIG. 3 extends longitudinally from an airflow inlet 146 into the CS air circuit 136 and its air circuit path 142 to an airflow outlet 148 from the CS air circuit 136 and its air circuit path 142 in an open loop. More particularly, the air circuit path 142 extends longitudinally from the air circuit inlet 146, sequentially through the flow regulator 144 and the CS heat exchanger 140, to the air circuit outlet 148. The present disclosure, however, is not limited to such an exemplary air circuit path arrangement. Moreover, it is contemplated the CS air circuit 136 may (or may not) also include one or more additional components arranged along the air circuit path 142. Examples of these additional components may include, but are not limited to, air filter(s), additional heat exchanger(s), additional flow regulator(s), sensor device(s), etc.

The air circuit inlet 146 of FIG. 3 fluidly couples the CS air circuit 136 and its air circuit path 142 to an air source volume 150 external to the cooling system 36. This air source volume 150 provides an air source for the cooling system 36 and its CS air circuit 136. More particularly, the air source volume 150 is configured to provide a flow of pressurized air (e.g., bleed air, ram air, etc.) to the CS air circuit 136 and its air circuit inlet 146. Referring to both FIGS. 1 and 3, the air source volume 150 may be internal to the aircraft propulsion system 22 (e.g., see internal locations 152A and 152B) or external to the aircraft propulsion system 22 (e.g., see external location 152C). For example, at the internal location 152A, the air source volume 150 is configured as the inlet flowpath 92. Here, the air circuit inlet 146 may be formed in a wall of the outer housing structure 30 along the outer peripheral boundary of the inlet flowpath 92. In another example, at the internal location 152B, the air source volume 150 is configured as the bypass flowpath 54. Here, the air circuit inlet 146 may be formed in a wall of the outer housing structure 30 along the outer peripheral boundary of the bypass flowpath 54. In still another example, at the external location 152C, the air source volume 150 is configured as the external environment 96. Here, the air circuit inlet 146 may be formed in a wall of the outer housing structure 30 along an exterior peripheral boundary of the aircraft propulsion system 22 (e.g., propulsion system housing 26) bordering the external environment 96. The air circuit inlet 146 may be configured as or otherwise include a bleed port (or multiple bleed ports) and/or a scoop (or multiple scoops) in and/or along the wall at the respective location 152A-C. The CS air circuit 136 of the present disclosure, however, is not limited to the foregoing exemplary air sources and/or circuit inlet arrangements.

The air circuit outlet 148 of FIG. 3 fluidly couples the CS air circuit 136 and its air circuit path 142 to an air sink volume 154 external to the cooling system 36. This air sink volume 154 provides an air sink for the cooling system 36 and its CS air circuit 136. More particularly, the air sink volume 154 is configured to receive the air exhausted from the CS air circuit 136 and its air circuit outlet 148, following use of that air by the cooling system 36 and its CS air circuit 136. Referring to both FIGS. 1 and 3, the air sink volume 154 may be internal to the aircraft propulsion system 22 (e.g., see internal locations 156A and 156B) or external to the aircraft propulsion system 22 (e.g., see external location 156C). For example, at the internal location 156A, the air sink volume 154 is configured as the outer housing compartment 90. In another example, at the internal location 156B, the air sink volume 154 is configured as the bypass flowpath 54. Here, the air circuit outlet 148 may be formed in the wall of the outer housing structure 30 along the outer peripheral boundary of the bypass flowpath 54. In still another example, at the external location 156C, the air sink volume 154 is configured as the external environment 96. Here, the air circuit outlet 148 may be formed in the wall of the outer housing structure 30 along the exterior peripheral boundary of the aircraft propulsion system 22 bordering the external environment 96. The air circuit outlet 148 may be configured as or otherwise include an outlet port (or multiple outlet ports) at the respective location 156A-C. The CS air circuit 136 of the present disclosure, however, is not limited to the foregoing exemplary air sinks and/or circuit outlet arrangements.

The flow regulator 144 of FIG. 3 is arranged fluidly inline along the air circuit path 142 between the air circuit inlet 146 and the air circuit outlet 148. The flow regulator 144 of FIG. 3, for example, is longitudinally spaced downstream of the air circuit inlet 146 along the air circuit path 142. This flow regulator 144 is also longitudinally spaced upstream of the CS heat exchanger 140 along the air circuit path 142. The present disclosure, however, is not limited to such an exemplary arrangement. For example, the flow regulator 144 may alternatively be disposed adjacent or may form the air circuit inlet 146.

The flow regulator 144 is configured to regulate the flow of pressurized air directed through the air circuit path 142 from the air circuit inlet 146 to (e.g., into) the CS heat exchanger 140. The flow regulator 144, for example, may be configured as or otherwise include a flow diverter, a control valve or a valve system. During a first mode of operation, the flow regulator 144 may open and fluidly couple a section of the air circuit path 142 upstream of the flow regulator 144 to a section of the air circuit path 142 downstream of the flow regulator 144. During a second mode of operation, the flow regulator 144 may close and fluidly decouple the upstream section of the air circuit path 142 from the downstream section of the air circuit path 142 (or facilitate a minimum flow of the pressurized air from the upstream section of the air circuit path 142 to the downstream section of the air circuit path 142). Of course, it is also contemplated the flow regulator 144 may operate in a third mode of operation where the flow regulator 144 partially opens (or partially closes) to facilitate an intermediate metered flow of the pressurized air from the upstream section of the air circuit path 142 to the downstream section of the air circuit path 142.

The CS liquid circuit 138 includes a liquid circuit path 158, the CS heat exchanger 140, one or more controller heat exchangers 160A and 160B (generally referred to as "160"), a liquid reservoir 162 and a liquid pump 164. This CS liquid circuit 138 is thermally coupled to the CS air circuit 136 through the CS heat exchanger 140. The CS liquid circuit 138 is thermally coupled to each EM controller 108 and its controller circuitry 120 through a respective one of the controller heat exchangers 160 as described below in further detail.

The liquid circuit path 158 of FIG. 3 extends longitudinally through the CS heat exchanger 140, the controller heat exchangers 160, the liquid reservoir 162 and the liquid pump 164 in a closed loop. The liquid circuit path 158 of FIG. 3, for example, includes one or more heat exchange legs 166A and 166B (generally referred to as "166") and a flow leg 168. Each of the heat exchange legs 166 extends longitudinally from an outlet from the flow leg 168, sequentially through the CS heat exchanger 140, a respective one of the controller heat exchangers 160, back through the CS heat exchanger 140, to an inlet into the flow leg 168. With this arrangement, the heat exchange legs 166 are fluidly coupled in parallel with one another between the flow leg inlet and the flow leg outlet. However, in other embodiments, it is contemplated the heat exchange legs 166 may alternatively be fluidly coupled in series between the flow leg inlet and the flow leg outlet. Referring again to FIG. 3, the flow leg 168 extends longitudinally from outlets from the heat exchange legs 166, sequentially through the liquid reservoir 162 and the liquid pump 164, to inlets into the heat exchange legs 166. The present disclosure, however, is not limited to such an exemplary liquid circuit path arrangement. Moreover, it is contemplated the CS liquid circuit 138 may (or may not) also include one or more additional components arranged along the liquid circuit path 158. Examples of these additional components may include, but are not limited to, filter(s), additional heat exchanger(s), flow regulator(s), sensor device(s), etc.

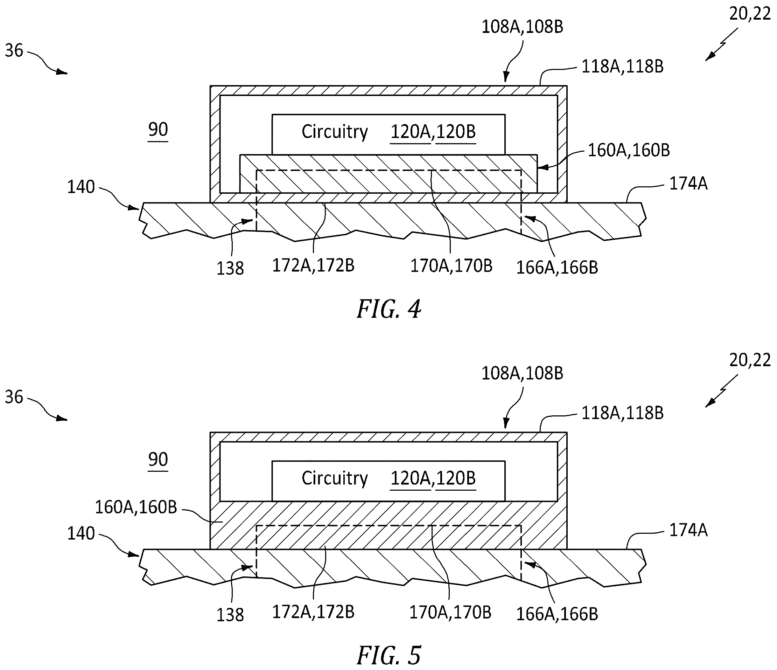

Each controller heat exchanger 160 is arranged in conductive thermal communication with a respective one of the EM controllers 108 and its respective controller circuitry 120. Each controller heat exchanger 160, for example, may be configured as a cooling plate to which the controller circuitry 120 of the respective EM controller 108 is mounted. More particularly, each controller heat exchanger 160A, 160B may be configured as a mass of thermally conductive material such as metal with one or more internal liquid circuit passages 170A, 170B (generally referred to as "170"; one schematically shown in FIG. 3). These liquid circuit passages 170 collectively form a longitudinal section of the respective heat exchange leg 166 through the respective controller heat exchanger 160. Referring to FIG. 4, each controller heat exchanger 160 may be disposed within the interior of the respective controller housing 118. The controller heat exchanger 160A, 160B of FIG. 4, for example, is arranged between and engages (e.g., abuts against, contacts, etc.) the respective controller circuitry 120A, 120B and a sidewall 172A, 172B (generally referred to as "172") of the respective controller housing 118A, 118B. Here, the controller heat exchanger 160 of FIG. 4 is mounted to and is in conductive thermal communication with the respective housing sidewall 172. The controller heat exchanger 160 of FIG. 4 thereby thermally couples the respective controller circuitry 120 to the respective housing sidewall 172 in thermal conduction. The present disclosure, however, is not limited to such an exemplary arrangement. The controller heat exchanger 160 of FIG. 5, for example, may alternatively be integrated as a part of the respective controller housing 118. More particularly, the controller heat exchanger 160 of FIG. 5 forms the respective housing sidewall 172.

Referring to FIG. 3, the controller heat exchangers 160 may also be arranged in conductive thermal communication with the CS heat exchanger 140. The EM controllers 108 of FIG. 3, for example, are arranged along and may be mounted to a common side 174A (e.g., a radial outer side) of the CS heat exchanger 140. Referring to FIG. 4, each controller housing 118 and its housing sidewall 172 may be mounted to and may be in conductive thermal communication with the CS heat exchanger 140. The controller heat exchanger 160 of FIG. 4 is thereby indirectly conductively thermally coupled to the CS heat exchanger 140 through the respective housing sidewall 172. Alternatively, referring to FIG. 5, each controller heat exchanger 160 may be mounted to and may be in conductive thermal communication with the CS heat exchanger 140. The controller heat exchanger 160 of FIG. 5 is thereby directly conductively thermally coupled to the CS heat exchanger 140.

Referring to FIG. 3, the liquid reservoir 162 is configured to contain a quantity of a liquid before, during and/or after cooling system operation. The liquid reservoir 162, for example, may be configured as or otherwise include a tank, a cylinder, a pressure vessel, a bladder or any other type of liquid storage container. The liquid stored within the liquid reservoir 162 (and circulated through the CS liquid circuit 138 and its liquid circuit path 158) may be a liquid working fluid such as lubricant (e.g., oil), coolant, hydraulic fluid and/or the like.

The liquid pump 164 of FIG. 3 is configured to direct and/or regulate a flow of the liquid through the liquid circuit path 158 from an outlet from (e.g., a supply of) the liquid reservoir 162, sequentially through the CS heat exchanger 140, through the controller heat exchangers 160 in parallel and back through the CS heat exchanger 140, to an inlet into (e.g., a return of) the liquid reservoir 162 for recirculation.

The CS heat exchanger 140 of FIG. 3 includes one or more internal air circuit passages 176 (one schematically shown in FIG. 3) and one or more internal liquid circuit passages 178A, 178B (generally referred to as "178"; one schematically shown for each heat exchange leg 166 in FIG. 3). The air circuit passages 176 collectively form a longitudinal section of the air circuit path 142 through the CS heat exchanger 140. Each set of the liquid circuit passages 178 collectively form a longitudinal section of a respective one of the heat exchange legs 166 within the CS heat exchanger 140. These liquid circuit passages 178 are fluidly independent from the air circuit passages 176. The air circuit passages 176 and each set of the liquid circuit passages 178 may be arranged to configure the CS heat exchanger 140 as a crossflow heat exchanger, a counterflow heat exchanger, a parallel flow heat exchanger, or a hybrid heat exchanger with a combination crossflow, counterflow and/or parallel flow arrangement with respect to the air circuit passages 176 and the respective set of the liquid circuit passages 178. Here, the CS heat exchanger 140 is a liquid-to-air heat exchanger between the liquid circuit passages 178 and the air circuit passages 176.

During operation of the cooling system 36 of FIG. 3, the liquid pump 164 circulates the liquid through the CS liquid circuit 138. As the working fluid flows within each controller heat exchanger 160, heat energy generated by operation of the controller circuitry 120 of the respective EM controller 108 may transfer into the liquid through the respective controller heat exchanger 160. This transfer of the heat energy out of the controller circuitry 120 and into the liquid cools the controller circuitry 120 and heats the liquid. The now heated liquid is directed out of each controller heat exchanger 160, through the CS heat exchanger 140, and into the flow leg 168 where the heated liquid is returned to the liquid reservoir 162 for storage until being directed back to the CS heat exchanger 140 by the liquid pump 164. Note, by storing the heated liquid in the liquid reservoir 162, the liquid directed through the CS liquid circuit 138 outside of the CS heat exchanger 140 and the controller heat exchangers 160 may be less viscous and easier to pump. When the heated liquid is returned to the CS heat exchanger 140, this heated liquid is directed into the heat exchange legs 166. Simultaneously, the air circuit inlet 146 receives pressurized air from the air source volume 150. The flow regulator 144 directs this pressurized air into the CS heat exchanger 140. As the heated liquid and the pressurized air flow within the CS heat exchanger 140, at least some (or all) of the heat energy that was previously received from the controller circuitry 120 may transfer out of the liquid and into the pressurized air through the CS heat exchanger 140. This transfer of the heat energy out of the liquid and into the pressurized air cools the liquid and heats the pressurized air. The liquid may then be directed back into the controller heat exchangers 160 to repeat the foregoing process, while the heated pressurized air may be exhausted out of the CS air circuit 136 through the air circuit outlet 148 into the air sink volume 154. In addition to the foregoing, additional heat energy may also be transferred from the controller circuitry 120 of each EM controller 108 into the CS heat exchanger 140 through conduction across the respective controller heat exchanger 160. The CS heat exchanger 140 may then transfer at least some (or all) of this additional heat energy into the pressurized air for removal from the cooling system 36 as described above.

Referring to FIG. 1, where the air circuit outlet 148 is disposed at the internal location 156A, the pressurized air exhausted from the cooling system 36 and its CS air circuit 136 (see FIG. 3) may be utilized for venting the outer housing compartment 90. By contrast, where the air circuit outlet 148 is disposed at the internal location 156B, the pressurized air exhausted from the cooling system 36 and its CS air circuit 136 (see FIG. 3) may be directed into the bypass flowpath 54 for at least some thrust recuperation.

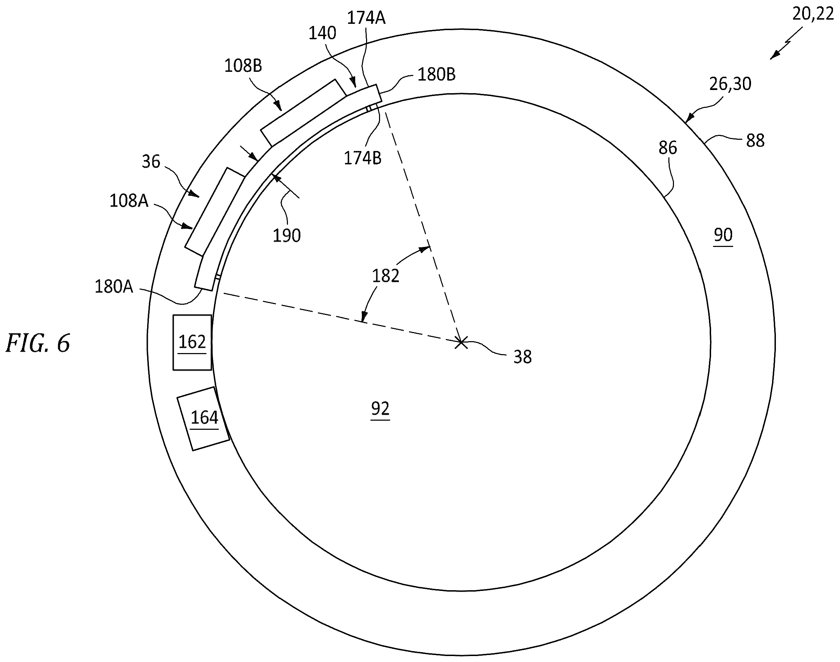

In some embodiments, referring to FIG. 6, the CS heat exchanger 140 may be mounted to the outer case 86. Here, the CS heat exchanger 140 is disposed radially between the EM controllers 108 and the outer case 86. The CS heat exchanger 140 of FIG. 6 may thereby form both a cooling device (e.g., a liquid-to-air cooling plate) for the EM controllers 108 as well as a mounting structure for the EM controllers 108.

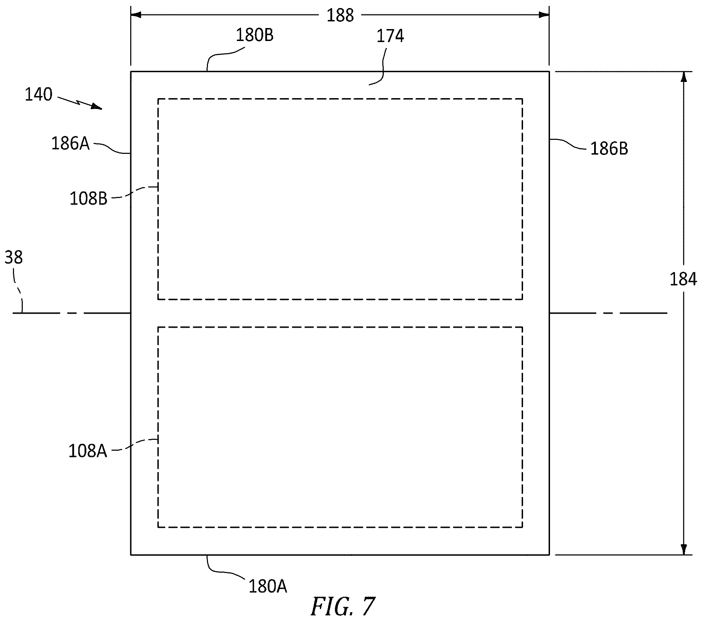

The CS heat exchanger 140 of FIG. 6 extends circumferentially about the propulsion system axis 38 between opposing circumferential sides 180A and 180B (generally referred to as "180") of the CS heat exchanger 140. These circumferential sides 180 of the CS heat exchanger 140 are angularly offset about the propulsion system axis 38 by an offset angle 182. This offset angle 182 may be equal to or greater than five degrees (5°) and/or equal to or less than sixty degrees (60°) or even ninety degrees (90°). The offset angle 182, for example, may be between ten degrees (10°) and forty degrees (40°), inclusive. Moreover, referring to FIG. 7, the circumferential sides 180 of the CS heat exchanger 140 are dimensionally separated by a circumferential length 184 of the CS heat exchanger 140. Opposing axial ends 186A and 186B (generally referred to as "186") of the CS heat exchanger 140 are dimensionally separated by an axial length 188 of the CS heat exchanger 140. Referring again to FIG. 6, opposing outer and inner sides 174A and 174B (generally referred to as "174") of the CS heat exchanger 140 are dimensionally separated by a radial height 190 of the CS heat exchanger 140. The CS heat exchanger 140 of FIGS. 6 and 7 may be configured with a relatively high aspect ratios. For example, an aspect ratio between the circumferential length 184 to the radial height 190 may be equal to or greater than 10:1. In addition or alternatively, an aspect ratio between the axial length 188 to the radial height 190 may be equal to or greater than 10:1. With such an arrangement, the CS heat exchanger 140 may be provided with a relatively slim form factor. Provision of this relatively slim form factor may in turn facilitate provision of a radially slimmer outer housing structure 30 of FIGS. 1 and 6.

For ease of description, the cooling system 36 of FIG. 3 is described above as facilitating cooling for the EM controllers 108. The present disclosure, however, is not limited to cooling such exemplary electric devices. The cooling system 36, for example, may also or alternatively be configured to cool and/or otherwise service various other electric devices for the aircraft propulsion system 22, including an electronic engine controller (EEC) for the aircraft propulsion system 22 and its turbine engine 24.

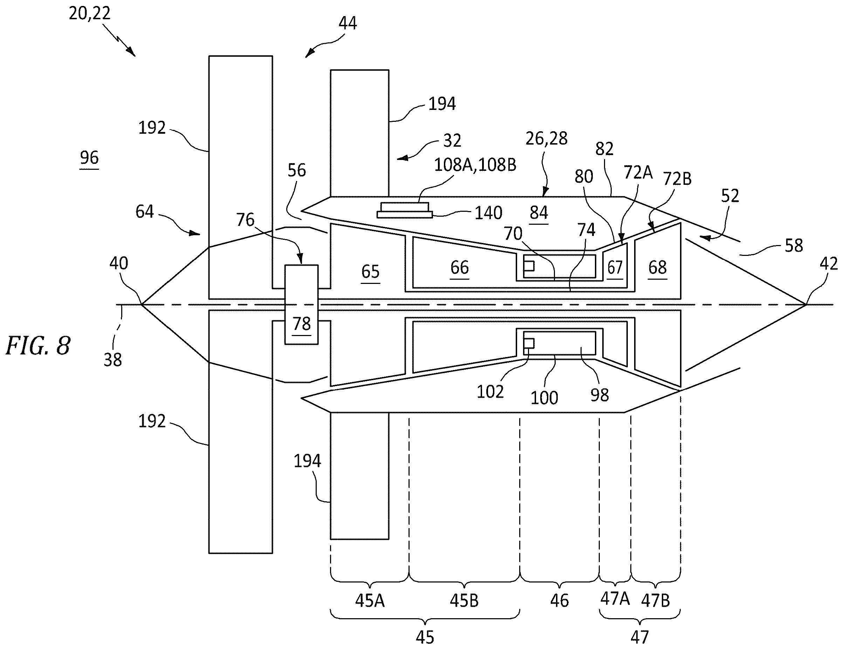

The aircraft propulsion system 22 of FIG. 1 is described above as a ducted propulsor propulsion system; e.g., the turbofan propulsion system. The present disclosure, however, is not limited to such an exemplary aircraft propulsion system. For example, referring to FIG. 8, the outer housing structure 30 (see FIG. 1) may be omitted from the propulsion system housing 26 to open the propulsor rotor 64 up to the external environment 96. More particularly, the propulsor rotor 64 of FIG. 8 includes a plurality of open propulsor blades 192 arranged circumferentially about the propulsion system axis 38 in an array; e.g., a circular array. This array of the propulsor blades 192 may be unshrouded or alternatively shrouded by a tubular propulsor rotor shroud dedicated to the propulsor rotor 64 for example. Each of these propulsor blades 192 projects spanwise (e.g., radially) out from a base of the propulsor rotor 64, into the external environment 96, to a distal tip of the respective propulsor blade 192. Each propulsor blade 192 is thereby configured as an un-ducted propulsor blade which is exposed to (e.g., disposed in) the surrounding external environment 96. With this arrangement, the propulsor rotor 64 is an open propulsor rotor (e.g., an un-ducted propulsor rotor) and the aircraft propulsion system 22 is configured as an open rotor propulsion system. Moreover, the inner housing structure 28 and its members may form an exterior of the aircraft propulsion system 22 and may border the external environment 96.

The guide vane structure 32 may also be open to the external environment 96 forming an open guide vane structure. This guide vane structure 32 of FIG. 8 includes a plurality of open exit guide vanes 194; e.g., airfoils. The guide vanes 194 are arranged and may (or may not) be equispaced circumferentially about the propulsion system axis 38 in an array; e.g., a circular array. This array of the guide vanes 194 may be unshrouded or alternatively shrouded by a tubular guide vane shroud dedicated to the guide vane structure 32 for example. This guide vane structure 32 and its guide vanes 194 are arranged axially next to (e.g., adjacent) the propulsor rotor 64 and its propulsor blades 192. The guide vane structure 32 and its guide vanes 194 of FIG. 8, for example, are arranged downstream of the propulsor rotor 64 and its propulsor blades 192, without (e.g., any) other elements axially therebetween to obstruct, turn and/or otherwise influence the air propelled by the propulsor rotor 64 to the guide vane structure 32. Each of the guide vanes 194 projects radially out from an exterior surface of the inner housing structure 28, into the external environment 96, to a distal tip of the respective guide vane 194. Each guide vane 194 is thereby configured as an un-ducted guide vane which is exposed to (e.g., disposed in) the surrounding external environment 96. With the foregoing arrangement, the guide vane structure 32 and its guide vanes 194 are configured to condition (e.g., straighten out, de-swirl, etc.) an outer stream of air propelled by the propulsor rotor 64 within the external environment 96 that bypass the engine core 50. Of course, in other embodiments, the guide vane structure 32 may be omitted where, for example, the aircraft propulsion system 22 is alternatively configured as a counter-rotating open rotor (CROR) aircraft propulsion system, etc.

While the turbine engine 24 in FIGS. 1 and 8 is described above with a particular two rotating structure arrangement (e.g., a two-spool architecture), the present disclosure is not limited thereto. For example, the LPC rotor 65 may be omitted to configure the LPT rotor 68 as a power turbine (PT) rotor for the propulsor rotor 64. The turbine engine 24 may also or alternatively include another rotating structure with a bladed compressor rotor in the compressor section 45 and a bladed turbine rotor in the turbine section 47; e.g., an intermediate speed spool for the engine core 50.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An assembly for an aircraft powerplant (20), comprising:
a first electric device (108A) including a first device heat exchanger (160A), a first device housing (118A) and first electrical circuitry (120A) housed within an interior of the first device housing (118A); and
a cooling system (36) including a liquid circuit (138), an air circuit (136) and a system heat exchanger (140), the cooling system (36) configured to cool the first electrical circuitry (120A) using a liquid flowing in the liquid circuit (138) and air flowing in the air circuit (136);
the liquid circuit (138) extending through the system heat exchanger (140) and the first electric device (108A), wherein the first device heat exchanger (160A) is configured to transfer heat energy from the first electrical circuitry (120A) into the liquid in the liquid circuit (138);
the air circuit (136) extending through the system heat exchanger (140), wherein the system heat exchanger (140) is configured to transfer at least some of the heat energy from the liquid in the liquid circuit (138) into the air in the air circuit (136); and
the first device housing (118A) attached to the system heat exchanger (140).

2. The assembly of claim 1, wherein the first device heat exchanger (160A) is integrated with the first device housing (118A).

3. The assembly of claim 1, wherein the first device heat exchanger (160A) is housed within the interior of the first device housing (118A).

4. The assembly of claim 1, 2 or 3, wherein the first device heat exchanger (160A) is conductively thermally coupled to the system heat exchanger (140).

5. The assembly of any preceding claim, wherein the liquid circuit (138) is configured as a closed loop liquid circuit (138).

6. The assembly of any preceding claim, wherein the liquid circuit (138) includes
a liquid reservoir (162);
a liquid pump (164); and
a liquid path (158) fluidly coupled to the liquid reservoir (162) and extending through the liquid pump (164), the system heat exchanger (140) and the first device heat exchanger (160A),
optionally wherein at least one of the liquid reservoir (162) and the liquid pump (164) is disposed outside of the first electric device (108A).

7. The assembly of claim 6, further comprising
a powerplant housing (26) comprising an internal compartment (90);
the first electric device (108A), the system heat exchanger (140), the liquid reservoir (162) and the liquid pump (164) disposed within the internal compartment (90).

8. The assembly of any preceding claim, wherein the air circuit (136) comprises a flow regulator (144) configured to regulate a flow of the air through the system heat exchanger (140).

9. The assembly of any preceding claim, wherein an inlet (146) into the air circuit (136) is fluidly coupled to an environment (96) external to the aircraft powerplant (20).

10. The assembly of any preceding claim, wherein an inlet (146) into the air circuit (136) is fluidly coupled to a volume (150) within the aircraft powerplant (20).

11. The assembly of any preceding claim, wherein an outlet from the air circuit (136) is fluidly coupled to an environment (96) external to the aircraft powerplant (20), or wherein an outlet (148) from the air circuit (136) is fluidly coupled to a volume (154) within the aircraft powerplant (20).

12. The assembly of any preceding claim, further comprising:
a second electric device (108B) including a second device heat exchanger (160B), a second device housing (118B) and second electrical circuitry (120B) housed within an interior of the second device housing (118B);
the cooling system (36) configured to cool the second electrical circuitry (120B) using the liquid flowing in the liquid circuit (138) and the air flowing in the air circuit (136);
the liquid circuit (138) further extending through the second electric device (108B), wherein the second device heat exchanger (160B) is configured to transfer additional heat energy from the second electrical circuitry (120B) into the liquid in the liquid circuit (138); and
the second device housing (118B) attached to the system heat exchanger (140).

13. The assembly of any preceding claim, wherein
the system heat exchanger (140) has a length (188) and a height (190); and
an aspect ratio of the length (188) to the height (190) is equal to or greater than ten.

14. The assembly of any preceding claim, further comprising:
an electric machine (106A);
the first electric device (108A) comprising an electric machine controller configured to control operation of the electric machine (106A).

15. The assembly of any preceding claim, further comprising:
a/the powerplant housing (26) comprising an/the internal compartment (90), the first electric device (108A) and the system heat exchanger (140) arranged within the internal compartment (90);
an engine core (50) housed within the powerplant (20) housing, the engine core (50) comprising a flowpath (52), a compressor section (45), a combustor section (46) and a turbine section (47), and the flowpath (52) extending through the compressor section (45), the combustor section (46) and the turbine section (47); and
a propulsor rotor (64), the engine core (50) configured to drive rotation of the propulsor rotor (64).
